Europäisches Patentamt

European Patent Office

Office européen des brevets

(11) Veröffentlichungsnummer: **0 013 860**
**B1**

# EUROPÄISCHE PATENTSCHRIFT

(45) Veröffentlichungstag der Patentschrift:
**28.07.82**

(21) Anmeldenummer: **79730013.4**

(22) Anmeldetag: **12.12.79**

(51) Int. Cl.³: **B 60 M 3/00,** H 02 H 3/06,
G 01 R 31/02

(54) Streckenprüfeinrichtung.

(30) Priorität: **20.01.79 DE 2902458**

(43) Veröffentlichungstag der Anmeldung:
**06.08.80 Patentblatt 80/16**

(45) Bekanntmachung des Hinweises auf die Patenterteilung:
**28.07.82 Patentblatt 82/30**

(84) Benannte Vertragsstaaten:
**AT BE CH FR IT NL**

(56) Entgegenhaltungen:
**DD-A-131 909**
**DE-B-1 143 221**
**DE-C-640 633**
**DE-C-748 987**

(73) Patentinhaber: **Licentia Patent-Verwaltungs-GmbH,
Theodor-Stern-Kai 1, D-6000 Frankfurt/Main 70 (DE)**

(72) Erfinder: **Herold, Thomas, Dipl.-Ing., Arnoldstrasse 11,
D-6050 Offenbach/Main (DE)**

(74) Vertreter: **Schickle, Gerhard, Dipl.-Ing., Licentia
Patent-Verwaltungs-GmbH Theodor-Stern-Kai 1,
D-6000 Frankfurt/Main 70 (DE)**

## Streckenprüfeinrichtung

Die Erfindung bezieht sich auf eine Strecken-prüfeinrichtung für über Streckenschalter ge-speiste Fahrleitungen, insbesondere für Gleich-stromfahrleitungen elektrischer Bahnen, bei der vor einem Wiedereinschalten des Streckenschalters eine Prüfstromquelle mittels einer Schalteinrichtung an die sonst spannungslose Fahrleitung angelegt wird, wobei der sich ergebende Prüfstrom als Kriterium für die Kurzschlussfreiheit der Strecke und für ein Wiedereinschalten des Streckenschalters dient.

Derartige Streckenprüfeinrichtungen arbeiten automatisch und sollen ein Aufschalten auf be-stehende oder fortdauernde Kurzschlüsse aus-schliessen. Bei den bekannten Streckenprüf-einrichtungen für Gleichstromfahrleitungen arbei-tet man im allgemeinen mit diskreten Widerständen, die durch Prüfschütze an die Betriebsspannung gelegt werden und einen maximal be-grenzten Prüfstrom fliessen lassen. Unter-schiedlich sind die Methoden der Auswertung. Teils erfolgt diese durch Messung des Prüfstromes direkt, teils durch Messung seines Spannungsabfalles entweder am Prüfwiderstand selbst oder insbesondere am sogenannten Restwiderstand. Dies ist der restliche Widerstand, bestehend aus Streckenwiderstand mit eingeschalteten Fahrzeughilfsbetriebswiderständen bis zur eventuellen Kurzschlussstelle.

Einerseits muss der Prüfstrom, der Messgenauigkeit wegen, und abhängig von den verwendeten Messeinrichtungen genügend gross sein, andererseits sollte mit Rücksicht auf Kosten und Platzbedarf von Prüfschütz und Prüfwiderstand der Prüfstrom möglichst klein ge-halten werden. Mit elektronischen Messeinrich-tungen können die erforderlichen Prüfströme bereits erheblich gesenkt werden (AEG-TFK Druck-schrift V1/524 1074 «Streckenprüfeinrichtung»).

Interessant wären Lösungen, mit denen sich der bisher notwendige Prüfwiderstand mit seinem Platzbedarf und nicht unerheblichen Leistungsverlusten ganz ausschalten liesse und bei herabgesetztem Prüfstrom die Streckenprüfeinrichtungen noch empfindlicher gemacht werden können.

Gelöst wird eine solche Aufgabe für eine Streckenprüfeinrichtung der eingangs genannten Art nach der Erfindung dadurch, dass als Schalteinrichtung ein steuerbarer Stromrichter dient, der direkt an die Fahrleitung angeschlossen ist und durch variable Zündung die Prüfspannung von Null aus in einem Zeittakt ansteigend bis zu einem Prüfstromgrenzwert erhöht, wobei dann das Wiedereinschalten des Strekkenschalters vom Verlauf des Prüfstromes un-terhalb eines kritischen Anstiegswertes abhän-gig ist.

Damit kann der bisher erforderliche Prüfwiderstand mit seinen Nachteilen vollends entfallen. Von Vorteil ist weiterhin die verschleisslose kontaktlose Schaltertechnik bei niedrigster Störanfälligkeit und hoher Messgenauigkeit der Gesamteinrichtung. Prüfströme von 5 bis 25 A reichen im allgemeinen aus.

In vorteilhafter Ausgestaltung der Erfindung schaltet der Stromrichter eine Wechselprüfspan-nung, wobei ein Anfangsaussteuerwinkel $\alpha =$ 180° des Stromrichters in einem Zeittakt von wenigen Periodenlängen der Prüfspannung je-weils um $\Delta\alpha \approx 1$ bis 2° bis zum Erreichen des Prüfstromgrenzwertes verkleinert wird. Sehr zweckmässig stellt sich die Verwendung jeweils einer einzigen Thyristorzelle pro Streckenfeld als Stromrichter, wobei der Thyristor parallel zum Streckenschalter einerseits an eine der Phasen eines die Fahrleitung über einen Gleichrichter speisenden Unterwerkstransformators und andererseits an die Fahrleitung angeschlossen ist. Die Steuerung kann für beliebig viele Strecken gemeinsam nur einmal vorhanden sein. Denkbar sind jedoch auch getrennte Lösungen.

Der Anstiegswert des Prüfstromes ist in einer vorteilhaften Ausgestaltung der Erfindung bei variablem Aussteuerwinkel $\alpha$ durch eine in den Zündzeitpunkten vorgenommene di/dt-Messung unter Verwendung eines als Differentiator geschalteten Operationsverstärkers ermittelbar. Besonders zweckmässig stellt sich jedoch in einer Modifikation zur Ermittlung des Anstiegswertes des Prüfstromes bei variablem Aus-steuerwinkel $\alpha$ die Verwendung eines Zählers. Dieser, vorzugsweise ein Binärzähler, zählt die Anzahl der Zeittaktschritte bis zum Erreichen des Prüfstromgrenzwertes und sperrt bei Un-terschreiten einer Zählschwelle die Wiederein-schaltung des Streckenschalters. Dabei ist es günstig, wenn die Zählschwelle digital mit einem dual-in-line-Schalter definiert einstellbar ist. Weitere vorteilhafte Ausgestaltungen sind den Ansprüchen 7 und 8 entnehmbar.

Anhand von schematischen Ausführungsbeispielen wird die Erfindung im nachstehenden näher erläutert:

Es zeigen:

Fig. 1 ein Prinzipschaltbild für eine Streckenprüfeinrichtung nach der Erfindung,

Fig. 2 eine Steuer-, Mess- und Regeleinrichtung für eine Einrichtung nach Fig. 1.

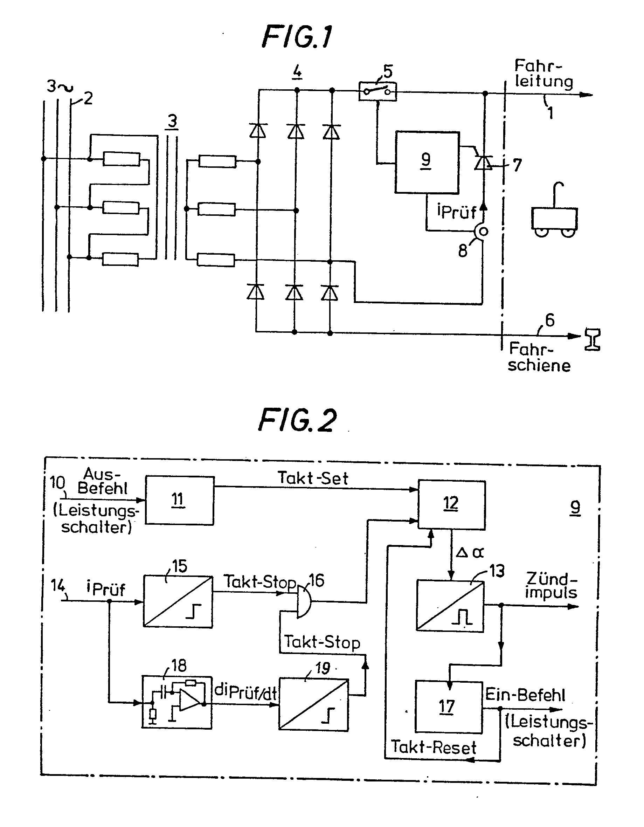

Die Fig. 1 zeigt eine Gleichstromfahrleitung 1, die von einem Drehstrombahnnetz 2 über einen Unterwerkstransformator 3 mit Bahngleichrich-ter 4 sowie einen Streckenschalter 5 gespeist wird. Rückleitung ist die Fahrschiene 6. Mit 7 ist noch ein Thyristor, mit 8 ein Prüfstromwandler und mit 9 eine symbolisiert dargestellte Steuer- und Messeinrichtung für diverse Aufgaben dargestellt.

Im normalen Fahrbetrieb ist der Streckenschalter 5 geschlossen, die Fahrleitung 1 oder auch eine Stromschiene liegen an Betriebsspannung. Der Streckenschalter 5 schützt die Fahrleitung 1 vor Überströmen, wie sie bei Kurzschlüssen auftreten können und schaltet in solchen Fällen den betreffenden Streckenabschnitt schnell ab. Nach Schalterfall (Streckenschalter 5 «aus») wird in bekannter Weise (z.B. über Spannungsteiler) die Fahrleitung 1 auf Spannungsfreiheit geprüft und der eigentliche Prüfvorgang kann anlaufen. Liegt dagegen Fremdspannung auf der Fahrleitung 1, erfolgt eine Meldung zur Schaltzentrale und der Prüfvorgang unterbleibt. Bei positivem Testergebnis, d.h. es liegt keine Spannung mehr auf der Fahrleitung 1, wird der Thyristor 7 taktweise gezündet, und es werden positive Halbwellenanschnitte der von einer Phase des Transformators entnommenen Wechselspannung als Prüfspannung auf die Fahrleitung 1 gegeben. Dabei wird von 0 Volt, d.h. einem Aussteuerwinkel $\alpha = 180°$ begonnen und dieser Aussteuerwinkel $\alpha$ im Zeittakt eines Taktgebers in der Steuer- und Messeinrichtung 9 um jeweils $\Delta\alpha \approx 1$ bis $2°$ verkleinert. Der dabei ansteigende impulsförmige Strom $I_{ss}$ wird über den Stromwandler 8 gemessen und einem schnellen Schmitt-Trigger in der Einrichtung 9 zugeführt. Bei Erreichen eines einstellbaren Prüfstromgrenzwertes $I_{Prüf\,max}$ von z.B. 5 bis 25 A spricht der Schmitt-Trigger an und stoppt den Taktgeber, wodurch der Aussteuerwinkel $\alpha$ konstantgehalten wird.

Der Prüfstromanstieg kann durch binäres Zählen — eines in der Einrichtung 9 befindlichen Binärzählers — der Schritte ermittelt werden, mit denen von $\alpha = 180°$ ausgehend der Prüfstromgrenzwert $I_{Prüf\,max}$ mit dem entsprechenden $\alpha$-Aussteuerungswinkel erreicht wurde. Dabei stellt ein gutes Prüfergebnis das Überschreiten einer einstellbaren Zählschwelle des Binärzählers dar. Die Zählschwelle lässt sich digital mit dual-in-line switches manuell kodiert wählen (definierte Einstellung). Bleibt das Zählergebnis nach Erreichen von $I_{Prüf}$ kleiner als die eingestellte Zählschwelle, ist das Prüfergebnis schlecht, und ein Einschaltbefehl für den Streckenschalter 5 wird gesperrt. Der Prüfvorgang muss wiederholt werden, was zweckmässig in definiert festen Zeitabständen nach einem Programm erfolgt. Dabei kann die Anzahl n der Prüfvorgänge ebenfalls in dual-in-line switches manuell kodiert festgelegt werden.

Anstelle einer Zählfeststellung des Prüfstromanstieges kann auch bei variablem $\alpha$ in den Zündzeitpunkten jeweils eine direkte di/dt-Messung vorgenommen werden. Ohmscher oder induktiver Charakter einer Energiespeisung werden durch di/dt Messung erfasst. Die di/dt-Messung kann mittels eines bekannten als Differenzierer geschalteten analogen Operationsverstärkers durchgeführt werden. Die Anordnungen dazu befinden sich dann ebenfalls in der Einrichtung 9.

Die beschriebenen beiden Möglichkeiten zur Stromanstiegsmessung lassen sich auch kombiniert anwenden.

Die Fig. 2 zeigt die bisher in Fig. 1 nur symbolisch dargestellte Steuer- und Messeinrichtung 9 detaillierter. Hat, wie bereits zu Fig. 1 geschildert, der Streckenschalter 5 wegen eines Überstromes Ausschaltbefehl erhalten und abgeschaltet und ist die Fahrleitung 1 im Streckenabschnitt spannungsfrei, dann kann der Prüfvorgang anlaufen. Der Aus-Befehl für den Streckenschalter wird dazu über Leitung 10 auf einen Programmschalter 11 gegeben, der mit einem einstellbaren Wiederhol- und Prüfprogramm jeweils einen Taktgeber 12 einschaltet. Der Taktgeber gibt z.B. Zeittakte mit jeweils um $\Delta\alpha$ veränderter Taktbreite ab. Die Zündimpulsabgabe eines nachgeschalteten Zündimpulsgebers 13 wird damit zeitlich verändert, so dass der Thyristor 7 (in Fig. 1) seinen Aussteuerwinkel $\alpha$ — von $\alpha \approx 180°$ beginnend (entspricht 0 V) — im Zeittakt jeweils mit jedem Takt um $\Delta\alpha \approx 1$ bis $2°$ verkleinert (die Spannung steigt an). Damit fliesst ein mit kleiner werdendem Aussteuerwinkel $\alpha$ ansteigender Prüfstrom $i_{Prüf}$, der bei Erreichen des Prüfstromgrenzwertes $i_{Prüf\,max}$ einen Schmitt-Trigger 15 setzt und über ein ODER-Glied den Taktgeber 12 anhält. Mittels eines Impulszählers 17 wird die Anzahl der Takte oder Zündimpulse bis zum Erreichen des Prüfstromgrenzwertes gezählt. Bei Erreichen oder Überschreiten der Zählschwelle des Zählers 17 wird für den Leistungsschalter Einschaltbefehl gegeben, anderenfalls bleibt er gesperrt. Mit dem Einschaltbefehl für den Leistungsschalter wird der Taktgeber 12 zurückgesetzt und ein neuer Prüfvorgang kann mit einem neuen Ausschaltbefehl für den Leistungsschalter, wie geschildert, beginnen. Bei einem Ausbleiben des Leistungsschalter Ein-Befehls dagegen werden weitere Wiederholungen der Prüfung nach Programm bewirkt. Dazu können Anzahl und Zeitabstand der erneuten Prüfungen im Programmschalter 11 manuell kodiert festgelegt werden.

Nach Fig. 2 wird der Prüfstrom noch zusätzlich einem Differenzierer 18 für direkte di/dt-Messung zugeführt. Bei Überschreiten eines kritischen Grenzwertes $di_{Prüf}/dt > {}_{Prüf}dt_{krit}$ wird ein weiterer Schmitt-Trigger 19 gekippt und über ODER-Glied 16 ebenfalls der Taktgeber 12 gestoppt.

Durch die Erfindung lassen sich hochgenaue Messergebnisse erzielen. Die Streckenprüfeinrichtungen können nach der Erfindung kleiner, praktisch wartungsfrei und auch billiger gebaut werden.

**Patentansprüche**

1. Streckenprüfeinrichtung für über Streckenschalter (5) gespeiste Fahrleitungen (1), insbesondere für Gleichstromfahrleitungen elektrischer Bahnen, bei der vor einem Wiedereinschalten des Streckenschalters (5) eine Prüfstromquelle mittels einer Schalteinrichtung an die sonst spannungslose Fahrleitung angelegt wird, wobei der sich ergebende Prüfstrom als Kriterium für die Kurzschlussfreiheit der Strecke und für ein Wiedereinschalten des Streckenschalters (5) dient, dadurch gekennzeichnet, dass als Schalteinrichtung ein steuerbarer Stromrichter (7) dient, der direkt an die Fahrleitung (1) angeschlossen ist und durch variable Zündung die Prüfspannung von Null aus in einem Zeittakt ansteigend bis zu einem Prüfstromgrenzwert erhöht, wobei dann das Wiedereinschalten des Streckenschalters (5) vom Verlauf des Prüfstromes unterhalb eines kritischen Anstiegswertes abhängig ist.

2. Streckenprüfeinrichtung nach Anspruch 1, dadurch gekennzeichnet, dass der Stromrichter eine Wechselprüfspannung schaltet, wobei ein Anfangsaussteuerwinkel $\alpha = 180°$ des Stromrichters (7) in einem Zeittakt von wenigen Periodenlängen der Prüfspannung jeweils um $\Delta\alpha \approx 1$ bis 2° bis zum Erreichen des Prüfstromgrenzwertes verkleinert wird.

3. Streckenprüfeinrichtung nach Anspruch 2, dadurch gekennzeichnet, dass als Stromrichter ein Thyristor (7) Verwendung findet, der parallel zum Streckenschalter (5) einerseits an eine der Phasen eines die Fahrleitung (1) über einen Gleichrichter (4) speisenden Unterwerkstransformators (3) und andererseits an die Fahrleitung (1) angeschlossen ist.

4. Streckenprüfeinrichtung nach einem der Ansprüche 1 bis 3, dadurch gekennzeichnet, dass der Anstieg des Prüfstromes bei variablem Aussteuerwinkel $\alpha$ durch eine in den Zündzeitpunkten vorgenommene di/dt-Messung unter Verwendung eines als Differentiator geschalteten Operationsverstärkers ermittelbar ist.

5. Streckenprüfeinrichtung nach einem der Ansprüche 1 bis 3, dadurch gekennzeichnet, dass der Anstieg des Prüfstromes bei variablem Aussteuerwinkel $\alpha$ durch einen Zähler vorzugsweise Binärzähler, ermittelbar ist, der die Anzahl X der Zeittaktschritte bis zum Erreichen des Prüfstromgrenzwertes zählt und bei Unterschreiten einer Zählschwelle die Wiedereinschaltung des Streckenschalters sperrt.

6. Streckenprüfeinrichtung nach Anspruch 5, dadurch gekennzeichnet, dass die Zählschwelle digital mit einem dual-in-line-Schalter definiert einstellbar ist.

7. Streckenprüfeinrichtung nach einem der Ansprüche 1 bis 6, dadurch gekennzeichnet, dass der ansteigende impulsförmige Prüfstrom mittels eines Stromwandlers (8) erfasst wird und dass sekundärseitig ein auf den Prüfstromgrenzwert eingestellter Schmitt-Trigger (15) angeschlossen ist, der bei einem Ansprechen den Takt für die Prüfspannungsvergrösserung anhält.

8. Streckenprüfeinrichtung nach einem der Ansprüche 4 bis 6, dadurch gekennzeichnet, dass bei Unterschreiten der Zählschwelle bzw. Überschreiten des kritischen di/dt-Wertes der Prüfvorgang nach einem Programm in definierten Zeitabständen wiederholbar ist.

**Revendications**

1. Contrôleur de section de lignes de contact (1) alimentées par des interrupteurs de section (5), et en particulier de lignes de contact à courant continu d'un réseau de traction, dans lequel un dispositif de commutation applique, avant un réenclenchement de l'interrupteur de se section (5), une source de tension de contrôle à la ligne de contact normalement hors tension, le courant de contrôle ainsi abtenue constituant le critère d'absence de court-circuit sur la section et de réenclenchement de l'interrupteur de section (5), ledit contrôleur étant caractérisé en ce que le dispositif de commutation est constitué par un convertisseur statique (7) commande, qui est relié directement à la ligne de contact (1) et aumente, par amorçage variable à la cadence d'horloge, la tension de contrôle entre zéro et un valeur limite du courant de contrôle, le réenclenchement de l'interrupteur de section (5) dépendant alors de la variation du courant de contrôle au-dessous d'une vitesse de croissance critique.

2. Contrôleur de section selon revendication 1, caractérisé en ce que le convertisseur statique commute une tension de contrôle alternative, un angle de retard initial $\alpha = 180°$ et du convertisseur statique (7) étant diminué par pas $\Delta\alpha \sim 1$ à 2°, à une cadence de quelques périodes de la tension de contrôle, jusqu'à ce que la valeur limite du courant de contrôle soit atteinte.

3. Contrôleur de section selon revendication 2, caractérisé par l'utilisation comme convertisseur statique d'un thyristor (7), branché en parallèle avec l'interrupteur de section (5), d'une part sur une des phases d'un trasformateur (3) de sous-station alimentant la ligne de contact (1) par l'intermédiaire d'un redresseur (4), et d'autre part sur la ligne de contact (1).

4. Contrôleur de section selon une quelconque des revendications 1 à 3, caractérisé en ce que la vitesse de croissance du courant de contrôle est déterminée, pour un angle de retard a variable, par une mesure di/dt effectuée aux instants d'amorçage, à l'aide d'un amplificateur opérationnel branché en différentiateur.

5. Contrôleur de section selon une quelconque des revendications 1 à 3, caractérisé en ce que la vitesse de croissance du courant de contrôle est déterminée, pour un angle de retard $\alpha$ variable, par un compteur binaire de préférence, qui compte le nombre X des pas d'horloge jusqu'à ce que la valeur limite du courant de contrôle soit atteint, et bloque le réenclenchement de l'interrupteur de section quand un seuil de comptage n'est pas atteint.

6. Contrôleur de section selon revendication 5, caractérisé par l'ajustement numérique défini du seuil de comptage sur un interrupteur DIL.

7. Contrôleur de section selon une quelconque des revendications 1 à 6, caractérisé en ce que le courant de contrôle impulsionnel croissant est déterminé à l'aide d'un transformateur d'intensité (8); et le secondaire est relié à une bascule de Schmitt (15), ajustée à la valeur limite du courant de contrôle et dont la réponse

arréte les impulsions d'horloge augmentant la tension de contrôle.

8. Contrôleur de section selon une quelconque des revendications 4 à 6, caractérisé par un programme permettant de répéter l'opération de contrôle à des intervalles de temps définis lorsque le seuil de comptage n'est pas atteint ou la valeur critique DI/DT est dépassée.

**Claims**

1. Route section test equipment for overhead lines (1) supplied through route section switches (5), particularly for direct current overhead lines of electric railways, in which prior to the route section switch (5) being switched on again, a test current source is applied by means of a switching equipment to the overhead line otherwise free of voltage, wherein the resultant test current serves as a criterion for the freedom from short-circuit of the route section and for the route section switch (5) being switched on again, characterised thereby, that a controllable rectifier (7) serves as switching equipment, is connected directly to the overhead line (1) and through variable firing increases the test voltage from zero rising in a timing rhythm up to a test current limit value, wherein the renewed switching-on of the route section switch (5) is then dependent on the course of the test current below a critical value of rise.

2. Route section test equipment according to claim 1, characterised thereby, that the rectifier switches an alternating test voltage, wherein an initial drive angle $\alpha = 180°$ of the rectifier (7) is reduced in a timing rhythm of few period lengths of the test voltage each time by $\Delta\alpha \doteq 1$ to $2°$ until the test current limit value is reached.

3. Route section test equipment according to claim 2, charcterised thereby, that a thyrister (7) finds application as rectifier and is connected in parallel with the route section switch (5) on the one hand to one of the phases of a substation transformer (3) supplying the overhead line (1) through a rectifier (4) and on the other hand to the overhead line (1).

4. Route section test equipment according to one of the claims 1 to 3, characterised thereby, that the rise in the test current with variable drive angle $\alpha$ is determinable by a di/dt measurement undertaken at the instants of firing with the use of an operational amplifier connected as differentiator.

5. Route section test equipment according to one of the claims 1 to 3, characterised thereby, that the rise in the test current with variable drive angle $\alpha$ is determinable by a counter, preferably a binary counter, which counts the number X of the timing rhythm steps until the test current limit value is reached and, on a counting threshold being fallen below, blocks the renewed switching-on of the route section switch.

6. Route section test equipment according to claim 2, characterised thereby, that the counting threshold is digitally settable defined by a dual-in-line switch.

7. Route section test equipment according to one of the claims 1 to 6, characterised thereby, that the rising pulse-shaped test current is detected by means of a current converter (8) and that connected to the secondary side is a Schmitt trigger stage (15), which is set to the test current limit value and which on responding stops the rhythm for the test voltage increase.

8. Route section test equipment according to one of the claims 4 to 6, characterised thereby, that on the counting threshold being fallen below or on the critical value of di/dt being exceeded, the test operation is repeatable at defined time intervals according to a program.

## FIG.1

## FIG.2